Europäisches Patentamt

European Patent Office

Office européen des brevets

(11) Publication number: **0 460 621 A1**

# EUROPEAN PATENT APPLICATION

(21) Application number: **91109142.9**

(51) Int. Cl.5: **B32B 31/10, B29C 67/18**

(22) Date of filing: **04.06.91**

(30) Priority: **04.06.90 JP 145794/90**

(43) Date of publication of application:
**11.12.91 Bulletin 91/50**

(84) Designated Contracting States:
**DE FR GB**

(71) Applicant: **HAKUTO CO., LTD.**
**1-13, Shinjuku 1-chome Shinjuku-ku**
**Tokyo(JP)**

Applicant: **SANEI GIKEN CO., LTD.**

**6-4, Nishinagasuhigashidori 2-chome**
**Amagasaki-shi, Hyogo-ken(JP)**

(72) Inventor: **Miyake, Eiichi**
**7-D3-304, Senriminamimachi 3-chome**
**Toyonaka-shi, Osaka(JP)**

(74) Representative: **Henkel, Feiler, Hänzel &**
**Partner**
**Möhlstrasse 37**
**W-8000 München 80(DE)**

(54) **Vacuum laminator.**

(57) A vacuum laminator for laminating a photo-sensitive dry film (39) on a substrate (11) under vacuum condition comprises a vacuum chamber (2), an inlet chamber having an inlet shutter (4) and connected to the vacuum chamber through a first partition shutter (5), an outlet chamber having an outlet shutter (7) and connected to the vacuum chamber through a second partition shutter (6), a conveyor device (8) for conveying the substrate through the inlet, vacuum and outlet chambers, a lamination device located within the vacuum chamber to supply and laminate the film on the substrate which has been conveyed into the vacuum chamber, and vacuum sources (31-33) communicated with the inlet, vacuum and outlet chambers.

*Fig. 1*

This invention relates to a vacuum laminator which laminates a photo-sensitive dry film on substrates under vacuum condition.

Photo-sensitive dry films are laminated not only on a smooth surface of a substrate but also on a rugged one on which an electric circuit pattern has already been formed. In the latter case, a photo-sensitive dry film is used as a soldering mask or as a film for protecting the electric circuit pattern for a long period of time.

When laminating a film on a rugged substrate surface, air bubbles tend to form between the substrate and the film. The formation of such air bubbles is almost unavoidable when the lamination is done under atmospheric pressure.

Therefore, there has been proposed a lamination under vacuum condition in which manner the photo-sensitive material of the film slips into a small gap between the substrate and the film to avoid the formation of air bubbles.

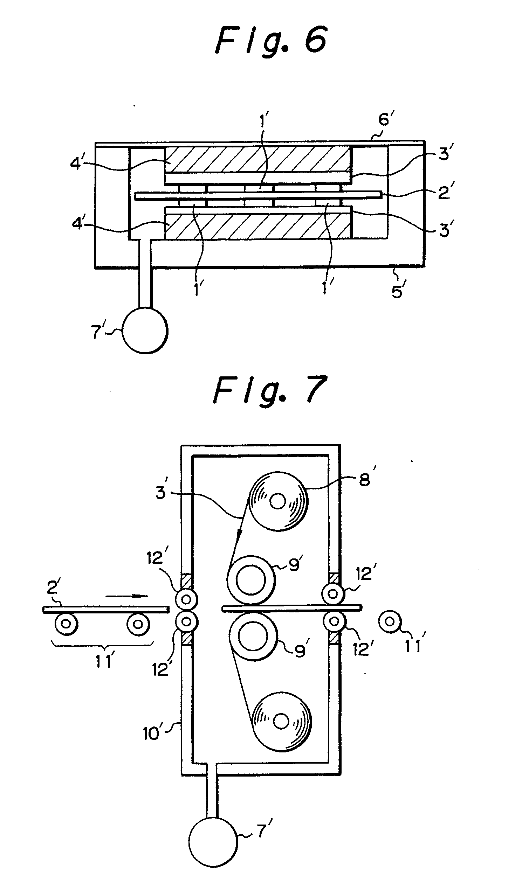

Fig. 6 is a cross-section of a conventional apparatus to laminate films on a substrate under vacuum condition, whose type is disclosed in Japanese Patent Publication (KOKOKU) No. 55-13341. Photo-sensitive dry films 3' are disposed on both sides of a substrate 2' on which an electric circuit pattern 1' has been formed. Elastic parts 4', which may be made from rubber, clamp therebetween the films 3' and the substrate 2' to form a composite. This composite is then placed on the bottom of a box 5' and the top of the box 5' is sealed by a flexible thin membrane 6'. Then, a vacuum pump 7' is actuated to decrease the pressure in the box 5' to vacuum. This apparatus is intended to laminate the photo-sensitive material of the films 3' to the substrate 2' and the electric circuit pattern 1' thereon without any gaps therebetween by the above mentioned operations.

With the above construction, however, the elastic parts 4' press the films 3' hard on the substrate 2' as soon as the pressure in the box 5' is decreased, due to the difference in pressure between outside and inside of the box 5'. This sudden movement of the elastic parts 4' makes the photo-sensitive material of the film 3' fill grooves which are defined between the protruding linear portions forming the electric circuit pattern 1' and which are utilized as paths through which air is sucked. If the groove has been filled with the photo-sensitive material of the film 3' first at the both ends or two distant points of the groove, the air in the groove cannot be sucked but remains as an air bubble. Depending on the design of the electric circuit pattern, it is likely that air bubbles remain at several places on the substrates and, therefore, lower the reliability of the products. In addition, this conventional apparatus cannot perform continuous lamination.

Fig. 7 is a simplified cross-section of another conventional apparatus for laminating a film on a substrate under vacuum condition, whose type is as disclosed in Japanese Patent Publication (KOKOKU) No. 53-31670 and 59-3740 and Japanese Utility Model Publication (KOKOKU) No. 62-29226. The feature of this apparatus is that the whole assembly of a conventional laminator of continuous operation type is used as laminating means and housed in a vacuum chamber 10'. Substrates 2' are transported into the chamber 10' one after another, and a web of photo-sensitive dry film 3' which is wound in the form of a roll 8' is continuously withdrawn and laminated on the substrates 2' by means of pressure rollers 9'. It may be easy for those skilled in the art to replace the laminating means as shown in Fig. 7 by an automatic cutting laminator which is disclosed in U.S. Patent 4,659,419 and Japanese Patent Publication (KOKOKU) No. 62-49169 and which is equipped with film cutting mechanisms and film tacking mechanisms. In the conventional apparatus as shown in Fig. 7, the substrates 2' are transported into and out of the chamber 10' through an inlet and an outlet thereof. A pair of pinch rollers 12' which is sealed at rotational parts thereof is provided at each of the inlet and the outlet. Lamination is done in the vacuum chamber 10' from which the air is sucked by the vacuum pump 7'. Because pressure rollers are used as laminating means, there are few disadvantages in this apparatus that are found in the conventional apparatus of Fig. 6.

However, it is very difficult to seal the rotational parts of the pinch rollers 12' and the sealing material is soon worn. Accordingly, such a sealing is not reliable. Furthermore, the pinch rollers are in contact with the sealing material in a dried condition to avoid transferring any oil to the substrate. This structure brings dust which tends to adhere on the substrate, resulting in defective products.

An object of this invention is, therefore, to enable highly reliable film-lamination to the substrate under vacuum condition.

According to this invention, it is provided a vacuum laminator for laminating a photo-sensitive dry film on a substrate under vacuum condition, comprising: a vacuum chamber; an inlet chamber having an inlet shutter and connected to the vacuum chamber through a first partition shutter; an outlet chamber having an outlet shutter and connected to the vacuum chamber through a second partition shutter; conveyor means for conveying the substrate through the inlet, vacuum and outlet chambers; a lamination device located within the vacuum chamber to supply and laminate the film on the substrate which has been conveyed into the vacuum chamber; and vacuum source means communicated with the inlet, vacuum and outlet chambers.

The vacuum chamber can be used as vacuum source means for the inlet and outlet chambers.

The above mentioned lamination device may have a vacuum suction mechanism which sucks the photo-sensitive dry films and holds them thereon by vacuum suction force. The vacuum suction mechanism may be connected to a vacuum source which can provide a higher degree of vacuum than that of the pressure in the above mentioned vacuum chamber.

For the vacuum chamber, automatic air intake valves may be employed to automatically control the degree of vacuum. Each of the inlet and outlet chambers may be connected to the vacuum source via a valve and may be equipped with a valve operable to open to the atmosphere.

To laminate a film on a substrate by the vacuum laminator of this invention, the inlet shutter of the inlet chamber is first opened to permit the substrate to enter the inlet chamber, and the inlet shutter is closed. Thereafter, a vacuum is created in the inlet chamber. Then, the first partition shutter is opened, and the substrate is sent into the vacuum chamber. In the vacuum chamber, a film is laminated on the substrate by the lamination device. Next, the second partition shutter is opened, and the substrate is sent into the outlet chamber which has been evacuated to form a vacuum beforehand. Finally, the second partition shutter is closed, and then the outlet shutter is opened to get the substrate out.

The vacuum laminator of this invention provides highly reliable vacuum lamination because the vacuum condition in the vacuum chamber is securely maintained.

Furthermore, because the sealing for maintaining a vacuum is done by utilizing the shutters which do not contact the substrate, dust does not adhere on the substrate. This makes the lamination more highly reliable.

The speed of the substrate going through the inlet and outlet chambers is a major factor to enhance the productivity of this vacuum lamination, i.e. the number of products produced an hour. To pass the substrate fast through the inlet and outlet chambers, it is necessary to shorten the time for vacuum suction in the inlet and outlet chambers, the time for substrate conveyance, the time for shutter operation and the time for restoring the inlet and outlet chambers to atmospheric pressure from vacuum. Among the above operations, the vacuum suction to obtain a vacuum takes the longest time. In order to shorten the time for vacuum suction, it is necessary to perform the following three matters.

1. -to minimize the volume of the inlet and outlet chambers.
2. -to use a vacuum source of a large capacity.

3. -to minimize the flow resistance in the pipes connecting the chambers to the vacuum source.

Among the above matters, the first and the third matters are easy to implement, but the second matter, in which a vacuum source of a large capacity is needed, makes the apparatus large and costly. In one embodiment of this invention, this problem can be solved by using the vacuum chamber as a vacuum source for the inlet and outlet chambers. Since the vacuum chamber is needed to house the whole of the lamination device, it is necessarily has a large volume. In the case that the volume of the vacuum chamber is large enough compared to the volume of each of the inlet and outlet chambers, the degree of vacuum in the vacuum chamber is little affected when the vacuum chamber is utilized as a vacuum source for the inlet and outlet chambers. In one embodiment of this invention, the change of the degree of vacuum is within a few percent.

Similar to the conventional automatic cutting laminator, the laminating device located within the vacuum chamber may have a vacuum suction mechanism which sticks a photo-sensitive dry film thereto by vacuum suction force for the operation of tacking the film to the substrate or other operations. The operation of the vacuum suction mechanism is still effective in the vacuum chamber when the vacuum suction mechanism is communicated with a vacuum source which can provide a higher degree of vacuum than the pressure in the vacuum chamber.

By employing an automatic air intake valve in the vacuum chamber to control the degree of vacuum in the chamber, by connecting the inlet and outlet chambers to their respective vacuum source means via valves and by using a valve operable to open to the atmosphere for each of the inlet and outlet chambers, the degree of vacuum in the vacuum chamber can be maintained constant and a vacuum can be created quickly and individually at least in the inlet and outlet chambers.

The term or word "vacuum" used in the specification and claims means not only a perfect vacuum or a pressure condition close to a vacuum, but also a low pressure condition reduced enough not to produce air bubbles between the substrate and the film during practicing the invention, or a low pressure condition reduced enough for the vacuum suction mechanism to stick the film thereto by vacuum suction force.

The invention will be better understood from the following description of a preferred embodiment thereof, given by way of example only, reference being had to the accompanying drawings in which:

Fig. 1 is a simplified longitudinal cross-section of an embodiment of the vacuum laminator according to this invention;

Fig. 2 is a plan view of the vacuum chamber of Fig. 1, with the top wall thereof being removed;

Fig. 3 is a side view of a guide unit part of the embodiment of Fig. 1, with showing the lamination device in a crosssection;

Fig. 4 is a side view of the substrate on which a film has been completely laminated;

Fig. 5 is an enlarged cross section showing the structure of one embodiment of a shutter;

Fig. 6 is a cross section of a conventional vacuum laminator; and

Fig. 7 is a simplified cross section showing another example of conventional vacuum laminators;

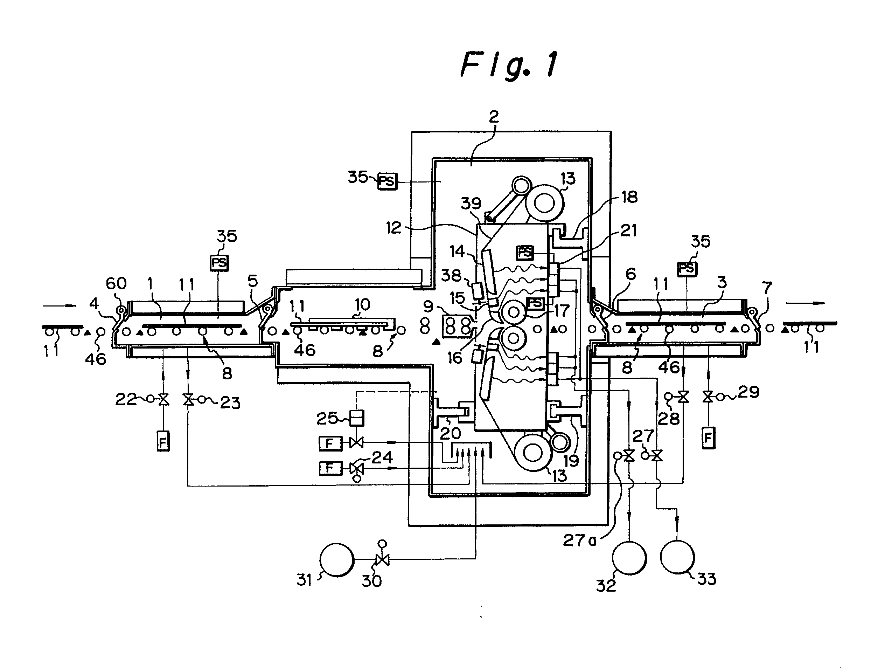

Referring now to Fig. 1, an inlet chamber 1, a vacuum chamber 2 and an outlet chamber 3 are connected in series and divided from each other by a first partition shutter 5 and a second partition shutter 6. The inlet chamber 1 and the outlet chamber 3 are equipped with an inlet shutter 4 and an outlet shutter 7, respectively. A roller conveyor 8 consisting of conveyor rollers 46 is provided as a conveyor means for conveying the substrate 11 through the inlet chamber 1, the vacuum chamber 2 and the outlet chamber 3. This roller conveyor 8 has a driving control system which can control its start/stop and speeds in the inlet chamber 1, the vacuum chamber 2 and the outlet chamber 3, individually.

The vacuum chamber 2 houses therein a centering mechanism 10 for laterally aligning the center of the substrate 11, a guide unit 9 for guiding the rear ends of the substrate 11 and the photosensitive dry films 39, and a lamination device 12.

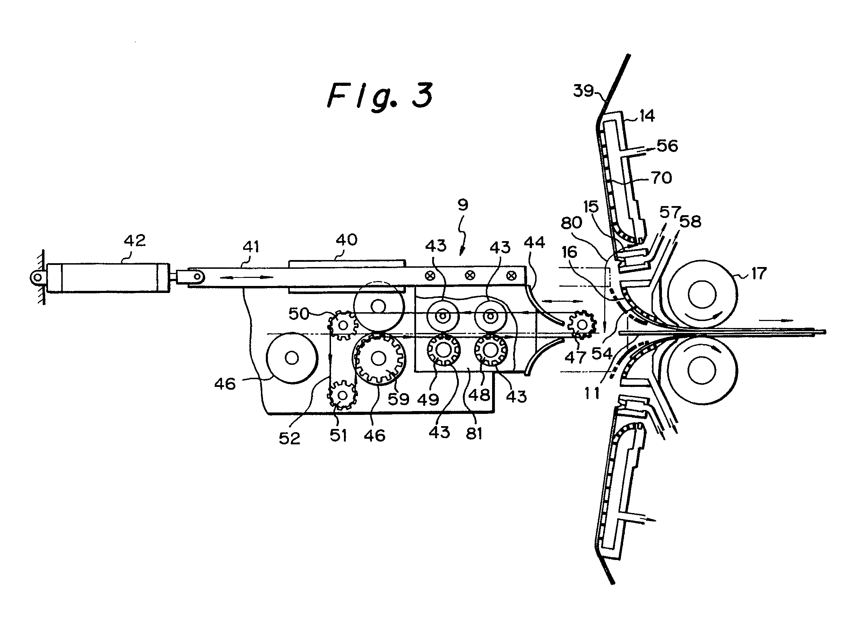

The lamination device 12 is equipped with tacking (pre-fitting) blocks 14 for temporarily secure the leading ends of the films 39 on the substrate 11, film cutting mechanisms for cutting the films 39, and heat-press rollers 17 for heat-press the cut films 39 on the substrate 11. Since the structure and functions of the lamination device 12 are identical or similar to those of the automatic cutting laminator as described in Japanese Patent Publication (KOKOKU) No. 62-49169, only a brief explanation is given here with referring to Figs. 1 and 3. When the substrate 11 is transported to a position short of the lamination device 12 and is stopped there, each tacking block 14 which holds the front end of the film 39 by vacuum suction force moves toward the substrate 11 with withdrawing the film 39 from a film roll 13. Each tacking block 14 tacks or temporarily secures the film end on the front end of the substrate 11. Then, each tacking block 14 moves away from the substrate 11 to the position shown in Fig. 1. The substrate 11 on which the front ends of the films 39 have been attached temporarily is sent forward and starts to be laminated with the films 39 by heat-press rollers 17. The films 39 are cut to film sheets each of which has a certain length fit to the length of the substrate 11 by rotary cutters 38 each of which moves at substantially the same speed and in the same direction as the film 39 moves. This film cutting operation is performed during the film laminating operation without interrupting the film laminating operation. Thus, the films 39 are laminated completely on the substrate 11. The lamination device 12 laminates the film sheets cut in the vacuum chamber 2 on the substrates 11 one by one.

The inlet chamber 1 and the outlet chamber 3 are connected to the vacuum chamber 2 through respective pipes having respective valves 23 and 28. These chambers 1 and 3 are provided with respective valves 22 and 29 which can be opened to atmosphere. The vacuum chamber 2 is connected to the vacuum pump 31 via a valve 30 and equipped with an automatic air intake valve 25 for controlling the degree of vacuum in the vacuum chamber 2 and a valve 24 which can be opened to atmosphere. The valves 22, 29, 24 and 25 take air in through filters F.

In each of the inlet chamber 1, the vacuum chamber 2 and the outlet chamber 3, a pressure sensor (PS) 35 is provided to detect if the internal pressure in the chamber is maintained within a desired range and to control the valves and the vacuum pump.

In the lamination device 12, each tacking block 14, whose function is to hold the film 39 by vacuum suction force, is connected to another vacuum pump 33 through a branching head 21 and a valve 27. The interior of each tacking block 14 is hollow to form a path for vacuum suction, and a number of through holes 70 (Fig. 3) are provided on a film holding surface of each tacking block 14. When the air is sucked in the direction as shown by an arrow 56 (Fig. 3), the film end is stuck on the film holding surface of each stacking block 14.

Cutter backups 15 and film guides 16 also have vacuum suction mechanisms each of which includes through holes and a path for vacuum suction, similar to those of the tacking blocks 14. The cutter backups 15 and the film guides 16 are connected to a vacuum pump 32 through the branching heads 21 and the valve 27a. When cutting the films 39 by the rotary cutters 38, the air is sucked in the direction as shown by an arrow 57 (Fig. 3) and the films 39 are hold on the cutter backups 15 sucks so that the films 39 can be surely cut by the cutters 38. At the center of each cutter backup 15, there is a lateral groove accommodated to receive a blade of the cutter 38. When the air is sucked in the direction as shown by an arrow 58, the film cut sheet during lamination is guided on the surface of each film guide 16 under an effect of suction force. Therefore, the rear end of the film cut sheet does not dangle on the substrate 11.

The vacuum pumps 32 and 33, to which the vacuum suction mechanisms for the tacking blocks 14, the cutter backups 15 and the film guides 16 are connected, are adapted to provide those mechanisms with a higher degree of vacuum than the reduced pressure in the vacuum chamber 2. Therefore, the vacuum suction mechanisms can provide the films with a vacuum suction effect even though they are positioned in the vacuum chamber 2.

A series of the processes in which the films 39 are laminated on the substrate 11 by the vacuum laminator according to this invention will be described below with reference to Figs. 1 and 3.

First, the inlet shutter 4 is opened while the first partition shutter 5 remains closed. The substrate 11 is transported into the inlet chamber 1 and is stopped there. The inlet shutter 4 is then closed. As the valve 23 is opened, the inlet chamber 1 is connected to the vacuum chamber 2 as a vacuum source, and a vacuum is created in the inlet chamber 1. Next, the first partition shutter 5 is opened and the substrate 11 is sent into the vacuum chamber 2 in which a vacuum has been created already. The substrate 11 is laterally centered by the centering mechanism 10 and is sent to the lamination device 12. The film cut sheets are laminated on the substrate 11 by the lamination device 12 as described above.

In the laminated state of the films 39, the photo-sensitive material 39a of each film 39 fills up the grooves without any gaps between protrusions formed by a pattern 11a of electric circuit, etc. on the substrate 11.

Before taking out substrate 11 which has been completely laminated with the films 39 from the vacuum chamber 2, a vacuum is created in the outlet chamber 3 by opening the valve 28 while the second partition shutter 6 and the outlet shutter 7 remains closed. The second partition shutter 6 is then opened and the substrate 11 is sent into the outlet chamber 3. The substrate 11 is stopped in the outlet chamber 3. After the second partition shutter 6 is closed to maintain the vacuum condition in the vacuum chamber 2, the valve 29 is opened so that the outlet chamber 3 communicates with the atmosphere. Thereafter, the outlet shutter 7 is opened to take out the substrate 11.

Thus, the lamination of one substrate 11 is completed and the laminated substrate is taken out of the vacuum laminator. An efficient and continuous lamination can be done by properly controlling the operations of each shutter and each valve. For instance, right after the substrate 11 is sent from the inlet chamber 1 to the vacuum chamber 2 and the first partition shutter 5 is closed, the inlet chamber 1 can be connected to the atmosphere and the inlet shutter 4 can be opened to receive the next substrate 11 into the inlet chamber 1.

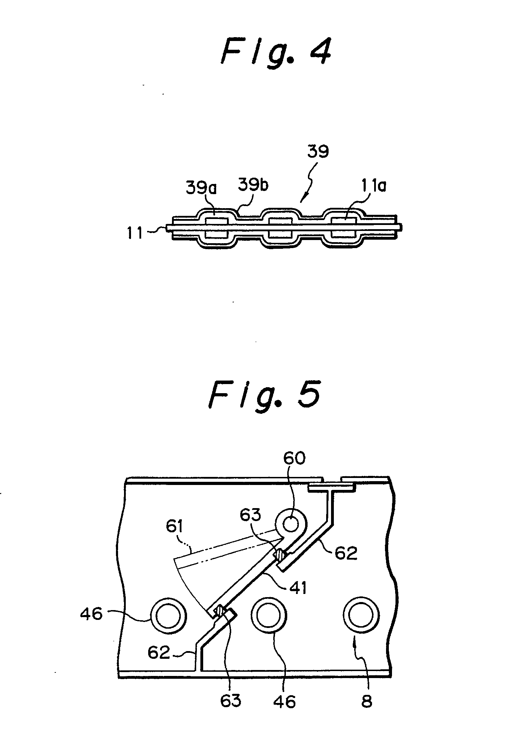

Each shutter may be of slide door type in which a shutter member slides to open. However, it makes the structure complicated and the sealing reliability a little low. Therefore, a shutter of swing door type as shown in Fig. 5 is preferred. The shutter shown in Fig. 5 has a swing door 61 pivotally mounted on a lateral shaft 60. A seal members 63 is provided around an opening in a base 62 to ensure the complete sealing when the swing door 61 is closed. In the illustrated embodiment, the door 61 is arranged obliquely so that it can move away from the transfer path of the substrate 11 when it opens even if the pitch between the adjacent rollers 46 of the roller conveyor 8 is small. If the shutter is arranged uprightly, the pitch between the adjacent rollers 46 would have to be larger. A smaller pitch of the rollers 46 makes the transference more reliable.

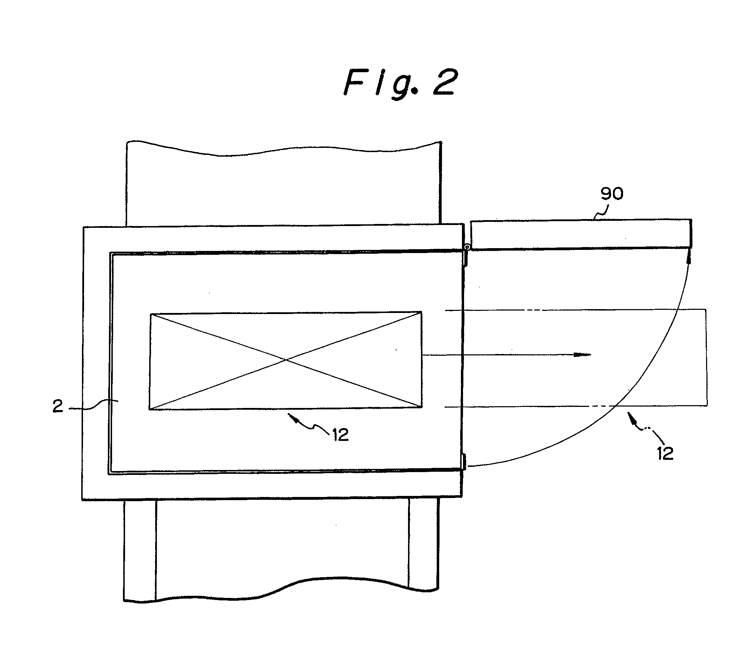

In order to facilitate the replacement of the film roll 13 and the maintenance work, the lamination device 12 may be adapted to be drawn on rails 18, 19 and 20 (see Fig. 1) out of the vacuum chamber 2 through an opened front door 90 as shown in Fig. 2.

As shown in Fig. 4, the photo-sensitive dry film 39 usually consists of three layers of a base film 39b, photo-sensitive material (photo-resist) 39a and a cover film (not shown). After the cover film is peeled off, the film 39 is laminated on the substrate 11 with the photo-sensitive material 39a facing inside and the base film 39b facing outside. In the past, relatively hard materials have been used for the base film 39b. However, to put the photo-sensitive material firmly without any gap on the substrate 11 whose surface is rugged because of electric circuit patterns, soft material or material that will soften by heat is preferred to be used for the base film 39b.

The structure and functions of the guide unit 9 will be described below with reference to an embodiment shown in Fig. 3.

The tacking block 14 moves close to and away from the substrate 11 along the path as shown by an arrow 80 to secure the leading end of the film to the substrate 11. To avoid that the rollers 46 of the roller conveyor 8 interferes the above motion of the tacking block 14, the rollers 46 cannot be located near the film guides 16. Because of this, when the substrate 11 is sent to the heat-press rolls 17, the substrate 11 extrudes as a cantilever from the rollers 46 located in a distant position from the film guides 16. Especially when the substrate is thin and there is imbalance of tension between the upper and lower films tacked on the substrate, the the substrate 11 tends to bend, resulting in the defective lamination. Furthermore, the film guides 16 which are to slidably hold the rear ends 54 of the film cut sheets thereon by vacuum suction force may, due to insufficient suction force, fail to hold the rear ends 54 of the films and the guides 16 may allow the rear ends 54 to come to contact with the substrate 11 before the heat-press rolls 17. This would result in wrinkles of the films on the substrate.

The guide unit 9 which consists of pinch rollers 43, plate guides 44 and a frame 81 solve the above problems.

Two upper pinch rollers 43 and two lower pinch rollers 43 are located in the transference path of the substrate and between the lamination device 12 and the roller 46 that is the closest roller of the roller conveyor 8. The pinch rollers 43 may be one pair, i.e., an upper one and a lower one, or may be three or more pairs. On the front side of the pinch rollers 43 (the right side in Fig. 3), plate guides 44 are provided. Both the pinch rollers 43 and the plate guides 44 laterally extend beyond the widths of the substrate 11 and the films 39, and are supported by the frame 81 at their both ends. The frame 81 is secured at its upper side to front ends of a pair of supporting rods 41 which are slidably guided in a pair of guide blocks 40. This means that the frame 81 is supported by the supporting rods 41. Rear ends of the supporting rods 41 are connected to a pair of the air cylinders 42. Therefore, the pinch rollers 43 and the plate guides 44 can be moved back and forth with the frame 81 by the action of the air cylinders 42.

A sprocket 59 mounted on the end of the shaft of the roller 46 which is driven by a motor (not shown) is engaged with a chain 52 which is put round idle sprockets 47, 50 and 51. Sprockets 48 and 49, which are mounted on the ends of the shafts of the lower pinch rollers 43, are also engaged with the chain 52. Therefore, when the roller 46 is driven to rotate, the pinch rollers 43 in the stationary guide unit 9 are also driven to rotate at the same peripheral speed as the roller 46 by the chain 52 and sprockets 49 and 48.

The guide unit 9 operates as follows. The substrate 11 sent by the conveyor rollers 46 is stopped at the position where the films 39 are tacked on the end of the substrate 11. The substrate 11 stops as the rollers 46 stop. The tacking blocks 14 holding the leading ends of the films by suction force approach the substrate 11 along the path 80, and the leading ends of the films 39 are tacked to the forward end portion of the substrate 11. After the tacking has finished, the tacking blocks 14 move away from the substrate 11 along the path 80 and goes back to the position shown in Fig. 3. The substrate 11, on which the film ends has been tacked, is advanced again by rotating the conveyor rollers 46. Simultaneously, the guide unit 9 is moved forward at substantially the same speed as the conveyance speed (the peripheral speed of the roller 46) by the air cylinders 42. The guide unit 9 is stopped at the position (as shown by the two-dot chain line in Fig. 3) where the plate guides 44 are close to the film guides 16. While the guide unit 9 is moving as the above, the pinch rollers 43 do not rotate because two operations tending to rotate the pinch rollers 43 in the opposite directions are offset; one is an operation by running the chain 52 tending to rotate the pinch rollers 43 in one direction and another is an operation by advancing the guide unit 9 tending to rotate the pinch rollers 43 in the reverse direction. As a result, the pinch rollers 43 clamp firmly the forward end of the substrate 11 and move close to the film guides 16. The forward end of the substrate 11 may start to be pinched by the heat-press rolls 17 either while the guide unit 9 is still moving, or after it has stopped. After the guide unit 9 has stopped, the pinch rollers 43 start rotating again at the same peripheral speed as the rollers 46 and advance the substrate 11. After the rear end of the substrate 11 passes through the guide unit 9, the guide unit 9 is moved backward to the position shown by the solid line in Fig. 3 by means of the air cylinders 42. Thus, by supporting the end of the substrate 11 at the position close to the film guides 16 by the movable guide unit 9, even thin substrate does not bend. In addition, even if the suction force of the film guides 16 is not enough, it is prevented by the plate guides 44 movable close to the film guides 16 that the film rear ends 54 come to contact with the substrate 11 before the heat-press rolls 17.

Of course, the guide unit 9 shown here can be applied not only to vacuum laminators but also to many other laminators generally used under atmospheric pressure. It is especially effective when applied to such an automatic cutting laminator as shown in Japanese Patent Publication (KOKOKU) No. 62-49169 as explained before, wherein conveyor rollers cannot be located near the film guides due to tacking operation. The guide unit 9 may be modified to a board guide unit consisting of pinch rollers 43 and a frame 81, by eliminating the plate guides 44. Especially when applied to a laminator operated under atmospheric pressure, since it is a rare case that the film guides 16 cannot utilize the sufficient suction force, the plate guides 44 can be eliminated. In an embodiment without the plate guides 44, the guide unit 9 can be moved backward when the forward end of the substrate 11 has started being clamped by the heat-press rolls 17. In addition, in either case, other driving devices can be used in place of the air cylinder 42.

It will be apparent to those skilled in the art that the disclosed vacuum laminator may be modified in numerous other ways and may assume many other embodiments in addition to the preferred forms specifically set out and described above. Accordingly, it is intended by the appended Claims to cover all such modifications of the invention which fall within the true spirit and scope of the invention.

## Claims

1. A vacuum laminator for laminating a photosensitive dry film on a substrate under vacuum condition, comprising:

    a vacuum chamber;

    an inlet chamber having an inlet shutter and connected to the vacuum chamber through a first partition shutter;

    an outlet chamber having an outlet shutter and connected to the vacuum chamber through a second partition shutter;

    conveyor means for conveying the substrate through the inlet, vacuum and outlet chambers;

    a lamination device located within the vacuum chamber to supply and laminate the film on the substrate which has been conveyed into the vacuum chamber; and

    vacuum source means communicated with the inlet, vacuum and outlet chambers.

2. The vacuum laminator according to claim 1, wherein said vacuum chamber is utilized as said vacuum source means for the inlet and outlet chambers.

3. The vacuum laminator according to claim 1 or 2, wherein said lamination device has a vacuum suction mechanism which sucks said film and holds it thereon by vacuum suction force and which is connected to a vacuum source for providing said vacuum suction mechanism with a higher degree of vacuum than that of the pressure in said vacuum chamber.

4. The vacuum laminator according to any one of preceeding claims, wherein said vacuum chamber has an automatic air intake valve for automatically controlling the degree of vacuum in the vacuum chamber, and each of said inlet and outlet chambers is connected to said vacuum source means via a valve and is provided with another valve operable to open to the atmosphere.

# Fig. 1

EP 0 460 621 A1

# Fig. 2

EP 0 460 621 A1

# Fig. 3

EP 0 460 621 A1

# Fig. 4

# Fig. 5

# Fig. 6

# Fig. 7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 215 358  (HITACHI CHEMICAL)<br>* page 9, line 17 - page 15, line 9; figure 1 * | 1,4 | B 32 B 31/10<br>B 29 C 67/18 |
| P,X | EP-A-0 392 226  (MITSUBISHI GAS CHEMICAL)<br>* column 9, line 23 - column 10, line 27 * * column 10, line 35 - line 45 * * column 14, line 12 - line 18; figures 1-5,7 * | 1,2 | |
| A | EP-A-0 360 269  (SOMAR)<br>* Abstract * * figures 5-12 * | 3 | |
| A,D | EP-A-0 125 584  (HAKUTO)<br>* the whole document * | 3 | |
| A | PATENT ABSTRACTS OF JAPAN vol. 12, no. 282 (M-726)(3129) August 3, 1988<br>& JP-A-63 59 517 (TOMOAKI ) March 15, 1988<br>* the whole document * | 1,2,4 | |
| A | EP-A-0 339 275  (SOMAR)<br>* column 6, line 31 - column 7, line 13; figures 1,6 * | | |

TECHNICAL FIELDS
SEARCHED (Int. Cl.5)

B 32 B
B 29 C

The present search report has been drawn up for all claims

| Place of search | Date of completion of search | Examiner |
|---|---|---|
| The Hague | 12 September 91 | PHILPOTT G.R. |